# EUROPEAN PATENT APPLICATION

(11) **EP 2 234 171 A1**
(43) Date of publication of application: **29.09.2010**
(21) Application number: 08871106.4
(22) Date of filing: 24.12.2008
(51) Int. Cl.: H01L 31/042, H01L 31/052

(54) **CONCENTRATING PHOTOVOLTAIC UNIT AND METHOD FOR MANUFACTURING CONCENTRATING PHOTOVOLTAIC UNIT**

(30) Priority: 17.01.2008 JP 2008008168
(71) Applicant: Sharp Kabushiki Kaisha, Osaka-shi Osaka 545-8522 (JP)
(72) Inventor: OKAMOTO, Chikao, Osaka-shi, Osaka 545-8522 JAPAN (JP); TANAKA, Masao, Osaka-shi, Osaka 545-8522 (JP)
(74) Representative: Müller - Hoffmann & Partner
(86) International application number: PCT/JP2008/073453
(87) International publication number: WO 2009/090843

(57) **Abstract**

A concentrating solar power generation unit 1 according to an embodiment of the present invention includes: a concentrating lens panel 10 in which a plurality of concentrating lenses 12 are arranged on a light transmitting panel substrate 11; a solar cell mounting plate 21 in which solar cells 20 are mounted corresponding to the concentrating lenses 12; and a first direction side supporting wall 32 that extends in a direction intersecting the solar cell mounting plate 21 and that supports a first direction side 13 of the light transmitting panel substrate 11, wherein a panel positioning portion 15 that defines the position of the concentrating lens panel 10 is formed in the first direction side 13, and a positioning portion-engagement portion 34 with which the panel positioning portion 15 is engaged is formed in an upper portion of the first direction side supporting wall 32.

## Description

### Technical Field

The present invention relates to a concentrating solar power generation unit that includes a concentrating lens panel in which a plurality of concentrating lenses are arranged, and a method for manufacturing such a concentrating solar power generation unit.

### Background Art

While solar power generation apparatuses (solar power generation units) that convert solar energy into electric power are in practical use, in order to achieve a cost reduction and obtain a large amount of electric power, concentrating solar power generation apparatuses (concentrating solar power generation units) that provide electric power by irradiating solar cell elements (solar cells) having a light-receiving area smaller than that of concentrating lenses with sunlight concentrated by the concentrating lenses are coming into practical use.

Because a concentrating solar power generation apparatus concentrates sunlight with the concentrating lenses and irradiates the solar cell elements with the sunlight, the solar cell elements have only a light-receiving area that is small enough to receive the sunlight concentrated by the optical system. In other words, the solar cell elements can be made smaller in size than the light-receiving area of the concentrating lenses, so the size of solar cell elements can be reduced, and the number of solar cell elements in the solar power generation apparatus, which are expensive components, can be reduced, resulting in a cost reduction. With these advantages, concentrating solar power generation apparatuses are coming into use as electric power supplies in regions where a large amount of area can be used for power generation.

A concentrating solar power generation apparatus has been proposed that provides sufficient strength, rigidity and heat dissipation properties with a simple configuration in which a solar cell module is attached to a support plate, without causing an increase in weight (see, for example, Patent Document 1).

The energy obtained by concentrating light at the light-receiving position is very large, so it is necessary to take heat dissipation measures as measures to prevent damage caused by irradiation of the peripheries of the solar cell elements with light. In addition, concentrating solar power generation apparatuses are often installed in regions where temperature changes are significant, such as deserts, so it is also necessary to take measures against thermal expansion caused by temperature increase. Furthermore, concentrating solar power generation apparatuses, which are intended primarily for outdoor use, are exposed to wind and rain, so it is necessary to take measures to prevent intrusion of water, sand, dust and the like.

As a result of taking these measures, in the concentrating solar power generation apparatus described in Patent Document 1, the heat dissipation structure, or in other words, the assembly structure has become complicated and large, which makes it, for example, difficult to perform positioning between solar cells and concentrating lenses, making the production process complicated. In other words, Patent Document 1 is problematic in terms of mass productivity, light concentrating accuracy (light concentrating properties) and the like.

When there is a problem with light concentrating properties, such as concentrated sunlight being deviated to a position away from the solar cell elements, the heat accumulating effect of the concentrated sunlight heats the solar cell module to high temperatures, which may cause problems in terms of heat resistance and reliability such as reducing the photoelectric conversion efficiency.

In addition, the water from rain and fog, sand, dust and the like entering from between concentrating lenses and a lens frame that holds the concentrating lenses may dirty the concentrating lenses and reduce the photoelectric conversion efficiency, which may cause problems in reliability.

Considering this background, there is a demand for a highly reliable concentrating solar power generation apparatus (concentrating solar power generation unit) that reliably provides power from concentrated sunlight with a structure that prevents intrusion of rain, water, sand, and the like, as well as a demand for a method for manufacturing such concentrating solar power generation apparatuses with good productivity in which the positioning of concentrating lenses (adjustment of positional relationship between solar cell elements and an optical system), the positioning of a lens assembly (light transmitting panel substrate) in which concentrating lenses are arranged, can be performed with high accuracy with a simple operation.
[Patent Document 1] JP H11-284217A

### Disclosure of Invention

### Problems to be Solved by the Invention

The present invention has been made in view of the above circumstances, and it is an object of the present invention to provide a concentrating solar power generation unit that is capable of easily and highly accurately positioning concentrating lenses and solar cells and that has superior light concentrating properties and heat resistance.

It is another object of the present invention to provide a method for manufacturing a concentrating solar power generation unit, with which it is possible to manufacture such concentrating solar power generation units with good productivity and low cost.

### Means for solving the Problems

A concentrating solar power generation unit according to the present invention is a concentrating solar power generation unit including: a concentrating lens panel in which a plurality of concentrating lenses are arranged on a rectangular light transmitting panel substrate; a solar cell mounting plate in which solar cells are mounted in correspondence with the concentrating lenses; and a first direction side supporting wall that extends in a direction intersecting the solar cell mounting plate and that supports a first direction side of the light transmitting panel substrate, wherein a panel positioning portion that defines a position of the concentrating lens panel is formed in the first direction side, and a positioning portion-engagement portion with which the panel positioning portion is engaged is formed in an upper portion of the first direction side supporting wall.

With this configuration, because the concentrating lens panel is positioned to the first direction side supporting wall with high accuracy by engaging the panel positioning portion and the positioning portion-engagement portion with each other, the concentrating lenses and the solar cells can be positioned easily and highly accurately, and therefore it is possible to obtain a concentrating solar power generation unit that has superior light concentrating properties and heat resistance.

In the above configuration, it is preferable that a reference positioning aperture is formed in the first direction side, and the panel positioning portion is formed covering the reference positioning aperture.

With this configuration, because the reference positioning aperture is formed in the first direction side, the panel positioning portion can be formed with respect to the reference positioning aperture, and therefore positioning accuracy can be achieved easily.

A concentrating solar power generation unit according to another aspect of the present invention is a concentrating solar power generation unit including: a concentrating lens panel in which a plurality of concentrating lenses are arranged on a rectangular light transmitting panel substrate; a solar cell mounting plate in which solar cells are mounted in correspondence with the concentrating lenses; and a first direction side supporting wall that extends in a direction intersecting the solar cell mounting plate and that supports a first direction side of the light transmitting panel substrate, wherein the concentrating solar power generation unit comprises a first direction side frame portion that is formed covering a perimeter edge of the first direction side, and the first direction side frame portion is provided with a panel positioning portion.

In this configuration, it is preferable that a frame insertion groove is provided that is formed in an upper portion of the first direction side supporting wall and in which the first direction side frame portion is inserted, and a positioning portion-engagement portion is formed in the frame insertion groove.

In this configuration as well, because the concentrating lens panel is positioned to the first direction side supporting wall with high accuracy by engaging the panel positioning portion and the positioning portion-engagement portion with each other, the concentrating lenses and the solar cells can be positioned easily and highly accurately, and therefore it is possible to obtain a concentrating solar power generation unit that has superior light concentrating properties and heat resistance.

With the concentrating solar power generation unit of the present invention, in the above configuration, it is preferable that the first direction side frame portion is in intimate contact with the frame insertion groove in a thickness direction of the first direction side frame portion.

With this configuration, because the frame insertion groove is hermetically sealed with the first direction side frame portion, and therefore the solar cells can be shielded from the external environment (rain, sand dust, and the like), the influence of the external environment can be eliminated, and weather resistance as well as reliability can be improved.

With the concentrating solar power generation unit of the present invention, in the above configuration, the first direction side frame portion and the concentrating lenses may be made of the same resin.

With this configuration, because it is possible to simultaneously form the concentrating lenses and the panel positioning portions and define their positional relationship with high accuracy, the positional relationship between the concentrating lenses and the solar cells can be defined easily and highly accurately, and the light concentrating properties can be further improved.

In the above configuration, it is preferable that the concentrating solar power generation unit of the present invention includes: a second direction side frame portion that is formed covering a perimeter edge of a second direction side that intersects the first direction side in the light transmitting panel substrate; and a second direction side supporting wall that extends in a direction intersecting the solar cell mounting plate and that supports the second direction side frame portion.

With this configuration, because all sides of the concentrating lens panel are supported and stabilized, it is possible to dispose a large number of concentrating lenses on the concentrating lens panel, and therefore a concentrating solar power generation unit can be obtained with good productivity and low cost.

With the concentrating solar power generation unit of the present invention, in the above configuration, the first direction side frame portion and the second direction side frame portion may be integrally molded.

With this configuration, the second direction side frame portion can be formed easily and highly accurately with good productivity and low cost.

In addition, a method for manufacturing a concentrating solar power generation unit according to the present invention is a method for manufacturing a concentrating solar power generation unit including: a concentrating lens panel in which a plurality of concentrating lenses are arranged on a rectangular light transmitting panel substrate; a solar cell mounting plate in which solar cells are mounted in correspondence with the concentrating lenses; and a first direction side supporting wall that extends in a direction intersecting the solar cell mounting plate and that supports a first direction side of the light transmitting panel substrate, the method including steps of forming a panel positioning portion that defines a position of the concentrating lens panel in the first direction side, and forming a positioning portion-engagement portion with which the panel positioning portion is engaged in an upper portion of the first direction side supporting wall.

A method for manufacturing a concentrating solar power generation unit according to another aspect of the present invention is a method for manufacturing a concentrating solar power generation unit including: a concentrating lens panel in which a plurality of concentrating lenses are arranged on a rectangular light transmitting panel substrate; a solar cell mounting plate in which solar cells are mounted in correspondence with the concentrating lenses; and a first direction side supporting wall that extends in a direction intersecting the solar cell mounting plate and that supports a first direction side of the light transmitting panel substrate, the method including: a frame portion forming step of forming a first direction side frame portion that covers a perimeter edge of the first direction side and a panel positioning portion that defines a position of the concentrating lens panel; and a lens panel connecting step of connecting the concentrating lens panel to the first direction side supporting wall by inserting the first direction side frame portion to a frame insertion groove that is disposed in an upper portion of the first direction side supporting wall and that is provided with a positioning portion-engagement portion with which the panel positioning portion is engaged, and engaging the panel positioning portion with the positioning portion-engagement portion.

With this configuration, because the concentrating lens panel is positioned to the first direction side supporting wall easily and highly accurately by engaging the panel positioning portion and the positioning portion-engagement portion with each other, the concentrating lenses and the solar cells can be positioned easily and highly accurately, and therefore it is possible to manufacture concentrating solar power generation units that have superior light concentrating properties and heat resistance with good productivity and low cost.

With the method for manufacturing a concentrating solar power generation unit of the present invention, in the above configuration, it is preferable that the frame portion forming step includes: a panel substrate placing step of placing the light transmitting panel substrate on a die; a lens resin injecting step of injecting a lens forming resin that forms the concentrating lenses on the light transmitting panel substrate into the die; a frame resin injecting step of injecting a frame portion forming resin that forms the first direction side frame portion into the die; and a resin curing step of curing the lens forming resin and the frame portion forming resin that have been injected into the die.

With this configuration, the concentrating lenses and the first direction side frame portions can be integrally formed with the concentrating lens panel, and therefore the concentrating lenses and the first direction side frame portions can be formed easily and highly accurately.

With the method for manufacturing a concentrating solar power generation unit of the present invention, in the above configuration, the lens forming resin and the frame portion forming resin are the same resin, and the lens resin injecting step and the frame resin injecting step are performed as a simultaneous resin injecting step of simultaneously injecting the same resin.

With this configuration, the concentrating lenses and the first direction side frame portions can be formed easily at low cost.

### Effects of the Invention

With the concentrating solar power generation unit of the present invention, because the concentrating lens panel is positioned to the first direction side supporting wall with high accuracy by engaging the panel positioning portion and the positioning portion-engagement portion with each other, it is possible to position a concentrating lens and a solar cell with ease and high accuracy and provide superior light concentrating properties and heat resistance.

In addition, according to the method for manufacturing a concentrating solar power generation unit of the present invention, it is possible to manufacture concentrating solar power generation units of the present invention with good productivity and low cost.

### Brief Description of Drawings

[FIG. 1] FIG. 1 is an exploded perspective view of a concentrating solar power generation unit, partially exploded so as to show a lens panel connecting step of a method for manufacturing a concentrating solar power generation unit according to Embodiment 1 of the present invention.
[FIG. 2] FIGS. 2 show enlarged explanatory diagrams of a panel positioning portion and a positioning portion-engagement portion of the concentrating solar power generation unit according to Embodiment 1 of the present invention, with FIG. 2(A) being an enlarged plan view as viewed from the sunlight incident side and FIG. 2(B) being an enlarged cross sectional view showing a cross section taken along the direction B-B of FIG. 2(A).
[FIG. 3] FIG. 3 is an enlarged cross-sectional view of a first direction side frame portion formed in a light transmitting panel substrate of the concentrating solar power generation unit according to Embodiment 1 of the present invention.
[FIG. 4] FIG. 4 is a plan view showing a plane configuration of a concentrating lens panel of the concentrating solar power generation unit according to Embodiment 1 of the present invention.
[FIG. 5] FIG. 5 is a partially exploded perspective view of a concentrating solar power generation unit according to Embodiment 2 of the present invention.
[FIG. 6] FIG. 6 is a plan view showing an arrangement of a die and a light transmitting panel substrate during a frame resin injecting step of a method for manufacturing a concentrating solar power generation unit according to Embodiment 3 of the present invention.
[FIG. 7] FIGS. 7 show enlarged cross sections of the arrangement of a die and a light transmitting panel substrate shown in FIG. 6, with FIG. 7(A) being an enlarged cross-sectional view taken along the line A-A of FIG. 6, and FIG. 7(B) being an enlarged cross-sectional view taken along the line B-B of FIG. 6.
[FIG. 8] FIG. 8 is a plan view showing an arrangement of a die and a light transmitting panel substrate during a frame resin injecting step of a method for manufacturing a concentrating solar power generation unit according to Embodiment 4 of the present invention.
[FIG. 9] FIG. 9 is an enlarged cross-sectional view showing a cross section of the arrangement of a die and a light transmitting panel substrate shown in FIG. 8 taken along the line Y-Y.
[FIG. 10] FIG. 10 is a plan view showing a plane configuration of a concentrating lens panel of a concentrating solar power generation unit according to Embodiment 5 of the present invention.
[FIG. 11] FIG. 11 is a partial plan view showing a relevant part of the concentrating lens panel of the concentrating solar power generation unit according to Embodiment 5 of the present invention.
[FIG. 12] FIG. 12 is an enlarged cross-sectional view showing a cross section of the arrangement of a die and a light transmitting panel substrate according to Embodiment 5 of the present invention shown in FIG. 10, taken along the line Z-Z of FIG. 10.
[FIG. 13] FIGS. 13 are diagrams used to illustrate a panel positioning portion of the concentrating lens panel of the concentrating solar power generation unit according to Embodiment 5 of the present invention, with FIG. 13(A) being a diagram showing a panel positioning portion and FIG. 13(B) being a diagram showing the panel fixed to a first direction side.
[FIG. 14] FIG. 14 is an enlarged cross-sectional view showing an arrangement of a die and a light transmitting panel substrate according to Embodiment 6 of the present invention.
[FIG. 15] FIG. 15 is a partial plan view showing a relevant part of a concentrating lens panel of a concentrating solar power generation unit according to Embodiment 7 of the present invention.
[FIG. 16] FIG. 16 is a diagram used to illustrate a reference positioning aperture of the concentrating lens panel of the concentrating solar power generation unit according to Embodiment 7 of the present invention.
[FIG. 17] FIG. 17 is an enlarged cross-sectional view showing an arrangement of a die and a light transmitting panel substrate according to Embodiment 7 of the present invention.
[FIG. 18] FIGS. 18 are diagrams used to illustrate a panel positioning portion of the concentrating lens panel of the concentrating solar power generation unit according to Embodiment 7 of the present invention, with FIG. 18(A) being a diagram showing a panel positioning portion and FIG. 18(B) being a diagram showing the panel fixed to a first direction side.

### Description of Reference Numerals

- 1: Concentrating Solar Power Generation Unit
- 1m: Concentrating Solar Power Generation Unit
- 10: Concentrating Lens Panel
- 11: Light Transmitting Panel Substrate
- 11a: Reference Positioning Aperture
- 11A: Positioning Aperture
- 12: Concentrating Lens
- 13: First Direction Side
- 13P: Pin
- 14: First Direction Side Frame Portion
- 15: Panel Positioning Portion
- 15P: Pin
- 15A: Pin
- 16: Second Direction Side
- 17: Second Direction Side Frame Portion
- 20: Solar Cell
- 21: Solar Cell Mounting Plate
- 30: Elongated Frame
- 31: Bottom Plate
- 32: First Direction Side Supporting Wall
- 33: Frame Insertion Groove
- 34: Positioning Portion-Engagement Portion
- 40: Second Direction Side Supporting Wall
- 50: Die
- 50b: Frame Forming Portion
- 50p: Positioning Portion-Forming Portion
- 51: Upper Die
- 51r: Resin Injection Inlet
- 52: Lower Die
- 52f: Concentrating Lens Forming Portion
- 52r: Resin Injection Inlet
- Dt: Thickness Direction

### Best Mode for Carrying Out the Invention

Hereinafter, embodiments of the present invention will be described with reference to the drawings.

### Embodiment 1

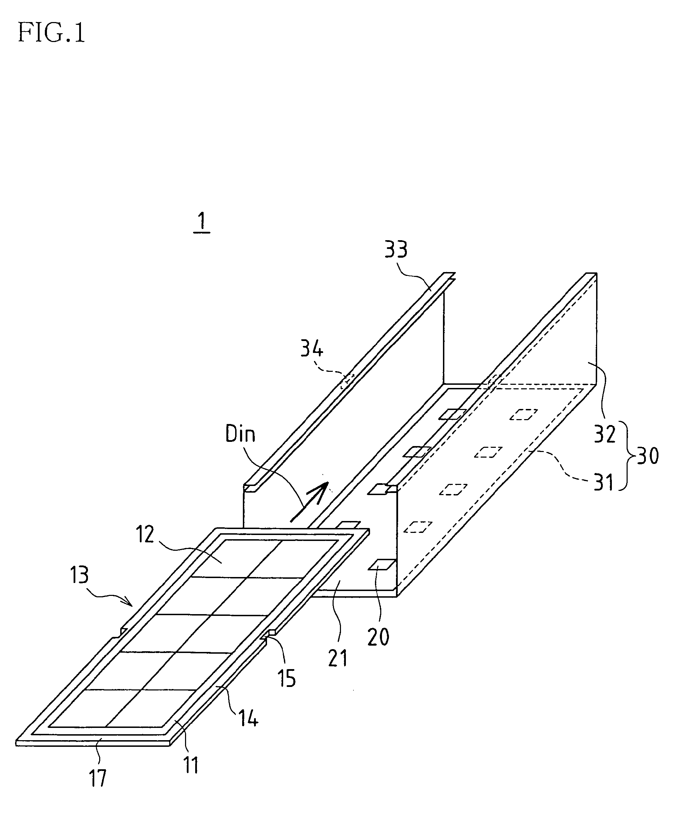

A concentrating solar power generation unit and a method for manufacturing a concentrating solar power generation unit according to the present embodiment will be described with reference to FIGS. 1 to 4.

FIG. 1 is an exploded perspective view of a concentrating solar power generation unit, partially exploded so as to show a lens panel connecting step of a method for manufacturing a concentrating solar power generation unit according to Embodiment 1 of the present invention.

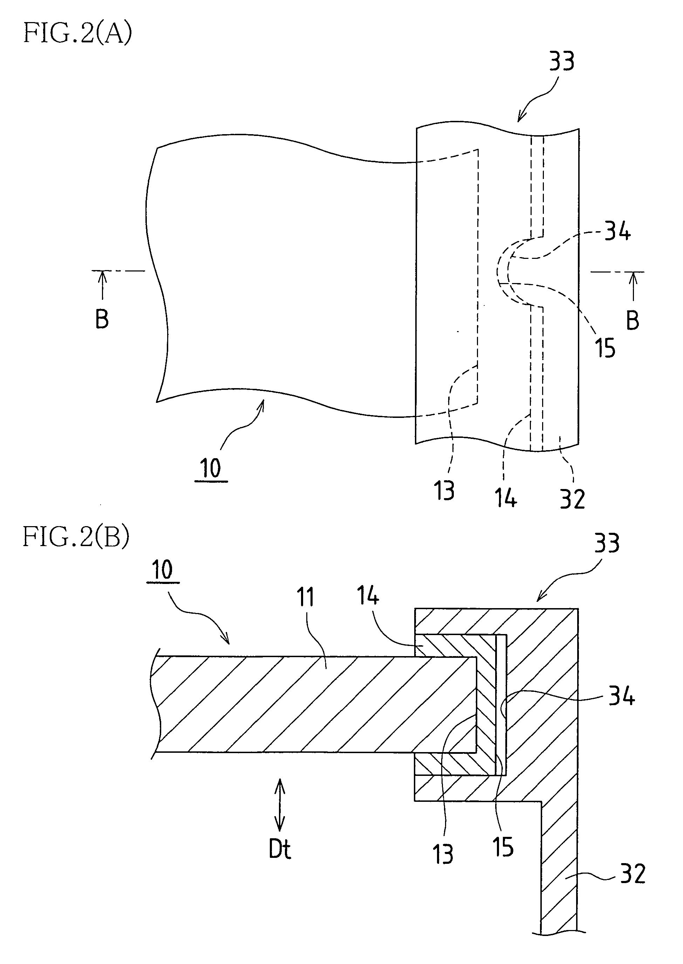

FIGS. 2 show enlarged explanatory diagrams of a panel positioning portion and a positioning portion-engagement portion of the concentrating solar power generation unit according to Embodiment 1 of the present invention, with FIG. 2(A) being an enlarged plan view as viewed from the sunlight incident side and FIG. 2(B) being an enlarged cross sectional view showing a cross section taken along the direction B-B of FIG. 2(A).

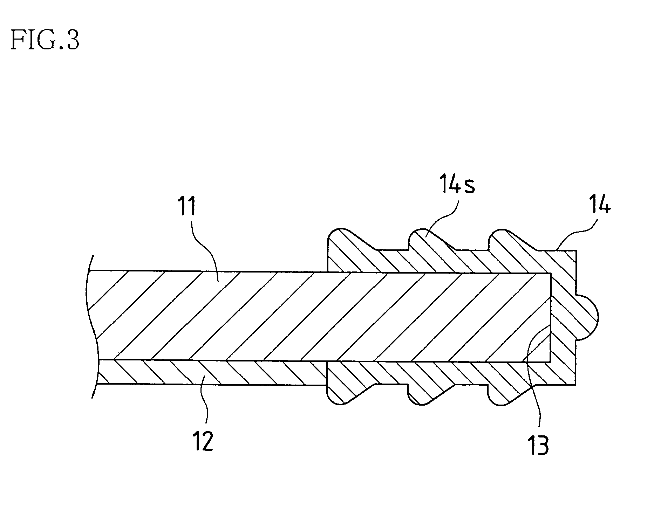

FIG. 3 is an enlarged cross-sectional view of a first direction side frame portion formed in a light transmitting panel substrate of the concentrating solar power generation unit according to Embodiment 1 of the present invention.

A concentrating solar power generation unit 1 according to the present embodiment includes a concentrating lens panel 10 in which a plurality of concentrating lenses 12 are arranged on a rectangular light transmitting panel substrate 11, a solar cell mounting plate 21 in which solar cells 20 are mounted corresponding to the concentrating lenses 12, and a first direction side supporting wall 32. The first direction side supporting wall 32 extends in a direction intersecting the solar cell mounting plate 21 to support a first direction side 13 of the light transmitting panel substrate 11.

The light transmitting panel substrate 11 is configured to have a rectangular shape, and therefore has a pair of first direction sides 13 that face each other and a pair of second direction sides 16 that face each other in a direction intersecting (perpendicular to) the first direction sides 13. The light transmitting panel substrate 11 has a function of concentrating light for the solar cells 20 and also functions as a protection member that protects the first direction side supporting walls 32 and the solar cells 20 from the external environment.

The pair of first direction side supporting walls 32 that are disposed facing each other in correspondence with the first direction sides 13 are integrally formed with a bottom plate 31, forming an elongated frame 30. The solar cell mounting plate 21 is attached to the bottom plate 31 as appropriate.

The overall elongated frame 30 is integrally formed including the first direction side supporting walls 32 and the bottom plate 31 by, for example, roll forming a metal plate such as an iron plate, steel plate or the like. By configuring the elongated frame 30 by using a metal plate such as an iron plate or steel plate, it is possible to secure mechanical strength and weather resistance.

The bottom plate 31 has sunlight irradiation holes (not shown) formed therein through which sunlight concentrated by the concentrating lenses 12 is directed to the solar cells 20. In other words, the solar cell mounting plate 21 is disposed on the underside of the bottom plate 31 (outside the elongated frame 30) and is configured to prevent damage by the concentrated sunlight.

The sunlight concentrated by the concentrating lenses 12 is directed to the solar cells 20 that are arranged in correspondence with to the concentrating lenses 12, and thereby the concentrating solar power generation unit 1 functions.

The light transmitting panel substrate 11 is made of, for example, glass in consideration of the light-transmitting properties, strength, environmental resistance and the like, and thus can eliminate the influence of wind and rain from the surrounding environment. It is also possible to use acrylic resin, polycarbonate or the like, instead of glass.

The concentrating lenses 12 can be bonded to the light transmitting panel substrate 11 with, for example, an appropriate adhesive. The concentrating lenses 12 can be made of, for example, acrylic resin in consideration of its processability, light-transmitting properties and the like. It is also possible to use polycarbonate, glass or the like, instead of acrylic resin. In the present embodiment, the light transmitting panel substrate 11 and the concentrating lenses 12 are made of different materials for the sake of convenience in describing the embodiment, but when the light transmitting panel substrate 11 and the concentrating lenses 12 are made of the same material, they can be integrally formed.

The concentrating solar power generation unit 1 includes first direction side frame portions 14 each formed covering a perimeter edge of the first direction side 13, panel positioning portions 15 that are formed in the first direction side frame portions 14 and that define the position of the concentrating lens panel 10, frame insertion grooves 33 that are each provided in an upper portion of the first direction side supporting walls 32 and into which the first direction side frame portion 14 is inserted, and positioning portion-engagement portions 34 that are each formed in the frame insertion grooves 33 and with which the panel positioning portion 15 is engaged.

With the above configuration, the concentrating lens panel 10 is positioned to the first direction side supporting walls 32 with high accuracy by engaging the panel positioning portions 15 and the positioning portion-engagement portions 34 with each other, so that the concentrating lenses 12 (the light transmitting panel substrate 11) and the solar cells 20 (the solar cell mounting plate 21) can be positioned easily and highly accurately, as a result of which a concentrating solar power generation unit 1 with superior light concentrating properties and heat resistance can be obtained.

The first direction side frame portions 14 are brought into intimate contact with the frame insertion grooves 33 in a thickness direction Dt of the first direction side frame portions 14 (see FIG. 2(B)). Accordingly, the frame insertion grooves 33 are hermetically sealed with the first direction side frame portions 14, so that the inside of the elongated frame 30 can be shielded from the external environment such as rain, sand dust and the like, as a result of which the influence of the external environment on the solar cells 20 is eliminated and the contamination of the concentrating lenses 12 and the solar cells 20 is prevented, so weather resistance and reliability can be improved.

Because the first direction side frame portions 14 are brought into intimate contact with the frame insertion grooves 33, the light transmitting panel substrate 11 is fixed to and held by the frame insertion grooves 33 (first direction side supporting walls 32) via the first direction side frame portions 14.

In other words, the frame insertion grooves 33 are provided with a U-shape and match the outer shape of the first direction side frame portions 14, which are formed on the perimeter edges of the first direction sides 13 of the light transmitting panel substrate 11. Accordingly, the groove width of the frame insertion grooves 33 corresponds to the thickness direction Dt of the first direction side frame portions 14, and is set to such a size that the first direction side frame portions 14 are fitted without creating a gap.

In addition, the first direction side frame portions 14 are configured to have a surface provided with appropriate minute projections 14s so as to have appropriate elasticity, thereby improving the slide when inserted into the frame insertion grooves 33, as well as the intimacy of contact with the frame insertion grooves 33 (see FIG. 3).

The positioning of the concentrating lenses 12 to the light transmitting panel substrate 11 can be performed directly by bonding, for example, ten concentrating lenses 12 that have been arranged to match the arrangement of the solar cells 20 to the light transmitting panel substrate 11. Alternatively, as described above, it is also possible to integrally form the light transmitting panel substrate 11 and the concentrating lenses 12. Accordingly, the concentrating lenses 12 predisposed on the light transmitting panel substrate 11 can be disposed in correspondence with the solar cells predisposed on the solar cell mounting plate 21 with high accuracy.

On the other hand, the bottom plate 31 (the solar cells 20 disposed via the solar cell mounting plate 21) and the frame insertion grooves 33 (first direction side supporting walls 32) can be positioned with high accuracy by the elongated frame 30 that is highly accurately formed by integrating the bottom plate 31 and the first direction side supporting walls 32.

Accordingly, in order to highly accurately position the solar cells 20 and the concentrating lenses 12, it is necessary to precisely position the light transmitting panel substrate 11 (concentrating lenses 12) to the bottom plate 31, or in other words, the first direction side supporting walls 32 (frame insertion grooves 33).

However, it is not easy to position the first direction side frame portions 14 corresponding to the first direction sides 13 of the light transmitting panel substrate 11 to the frame insertion grooves 33 of the elongated frame 30. In other words, a problem with accuracy arises when positioning is performed with respect to the outer perimeter edge of the light transmitting panel substrate 11 because the light transmitting panel substrate 11 holds a large number of concentrating lenses 12 and therefore has a large outer shape. In addition, the positioning of the light transmitting panel substrate 11 with respect to the solar cells 20 disposed on the bottom plate 31 via the solar cell mounting plate 21 is difficult because the distance between the solar cells 20 and the concentrating lenses 12 is large due to the spacing in the direction in which the first direction side supporting walls 32 extend, and thus their positions may appear to be different when viewed together.

In order to solve such problems, in the present embodiment, the panel positioning portions 15 are formed in the first direction side frame portions 14 so as to correspond to the center of the concentrating lenses 12 disposed on the light transmitting panel substrate 11, and the positioning portion-engagement portions 34 are formed in the frame insertion grooves 33 so as to correspond to the solar cells 20 disposed on the solar cell mounting plate 21.

In other words, as a positioning structure of the light transmitting panel substrate 11, the panel positioning portions 15 that define the position of the light transmitting panel substrate 11 are formed by being integrated with the first direction side frame portions 14 formed covering the perimeter edges of the first direction sides 13 of the light transmitting panel substrate 11 (frame portion forming step).

In the frame insertion grooves 33, positioning portion-engagement portions 34 with which the panel positioning portions 15 are engaged are formed in correspondence with the panel positioning portions 15. The positioning portion-engagement portions 34 can be formed and highly accurately disposed, matching the position of the solar cells 20 when forming the frame insertion grooves 33 while the integrally-formed elongated frame 30 including a bottom plate 31 and first direction side supporting walls 32 is formed.

Accordingly, by inserting the light transmitting panel substrate 11 into the frame insertion grooves 33 and engaging the panel positioning portions 15 with the positioning portion-engagement portions 34 (lens panel connecting step), the positioning between the light transmitting panel substrate 11 (concentrating lenses 12) and the frame insertion grooves 33 (the first direction side supporting walls 32 and the bottom plate 31) can be carried out with high accuracy. As a result, the positioning of the concentrating lenses 12 and the solar cells 20 can be carried out with ease and high accuracy with a simple operation.

As described above, with the concentrating solar power generation unit 1 in which the concentrating lenses 12 and the solar cells 20 are highly accurately positioned, the sunlight concentrated by the concentrating lenses 12 can be precisely directed to the solar cells 20. In addition, because unnecessary irradiation of sunlight does not occur in an area other than the solar cells 20 within the elongated frame 30, the concentrating solar power generation unit 1 can have superior light concentrating properties and heat resistance.

By configuring the positioning portion-engagement portions 34 to have, for example, a semi-cylindrical shape obtained by cutting a cylinder in half, the light transmitting panel substrate 11 (first direction side frame portions 14) can be smoothly inserted into the frame insertion grooves 33 (see FIGS. 2). Also, by configuring the panel positioning portions 15 to have, for example, a hollow semi-cylindrical shape obtained by cutting a hollow cylinder in half, the panel positioning portion 15 can be matched and engaged with the positioning portion-engagement portions 34 (see FIG S. 2).

The panel positioning portions 15 having a hollow semi-cylindrical shape have a radius slightly smaller than that of the positioning portion-engagement portions 34 having a semi-cylindrical shape, and therefore, even more accurate positioning is possible.

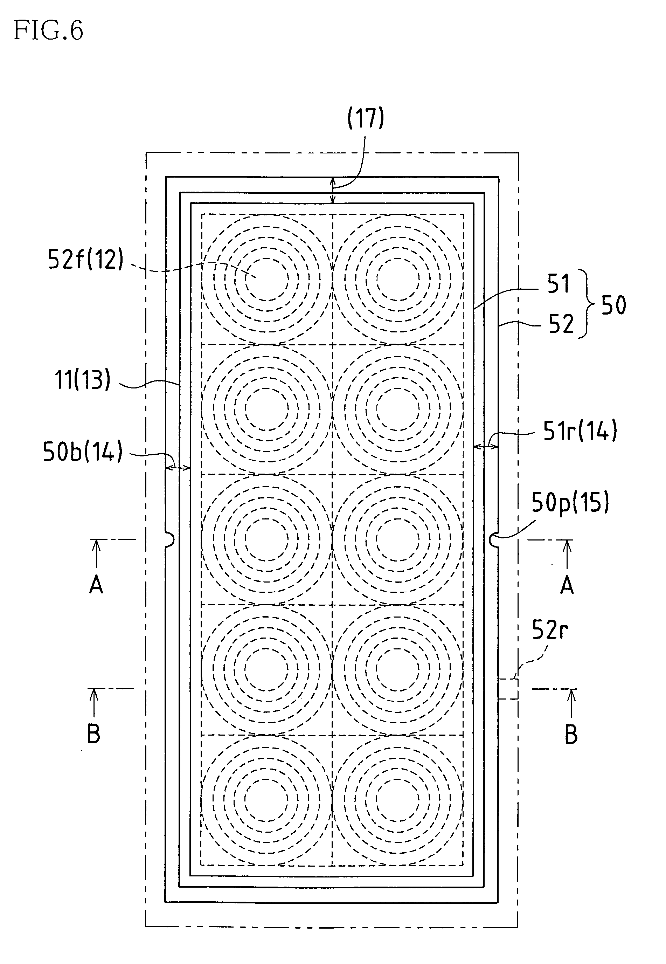

A concentrating solar power generation unit manufacturing method for manufacturing concentrating solar power generation units 1 according to the present embodiment includes: a frame portion forming step of forming first direction side frame portions 14 that cover the perimeter edges of first direction sides 13 and panel positioning portions 15 that define the position of a concentrating lens panel 10 (see Embodiments 3 and 4 and FIGS. 6 to 9); and a lens panel connecting step of connecting the concentrating lens panel 10 to first direction side supporting walls 32 by inserting the first direction side frame portions 14, in a direction Din, into frame insertion grooves 33 that are disposed in upper portions of the first direction side supporting walls 32 and that include positioning portion-engagement portions 34 with which the panel positioning portions 15 are engaged, and engaging the panel positioning portions 15 with the positioning portion-engagement portions 34.

As described above, the concentrating lens panel 10 is easily and highly accurately positioned to the first direction side supporting walls 32 by engaging the panel positioning portions 15 and the positioning portion-engagement portions 34 with each other, and therefore the concentrating lenses 12 and the solar cells 20 can be positioned easily and highly accurately. As a result, it is possible to manufacture concentrating solar power generation units 1 having superior light concentrating properties and heat resistance with good productivity and low cost.

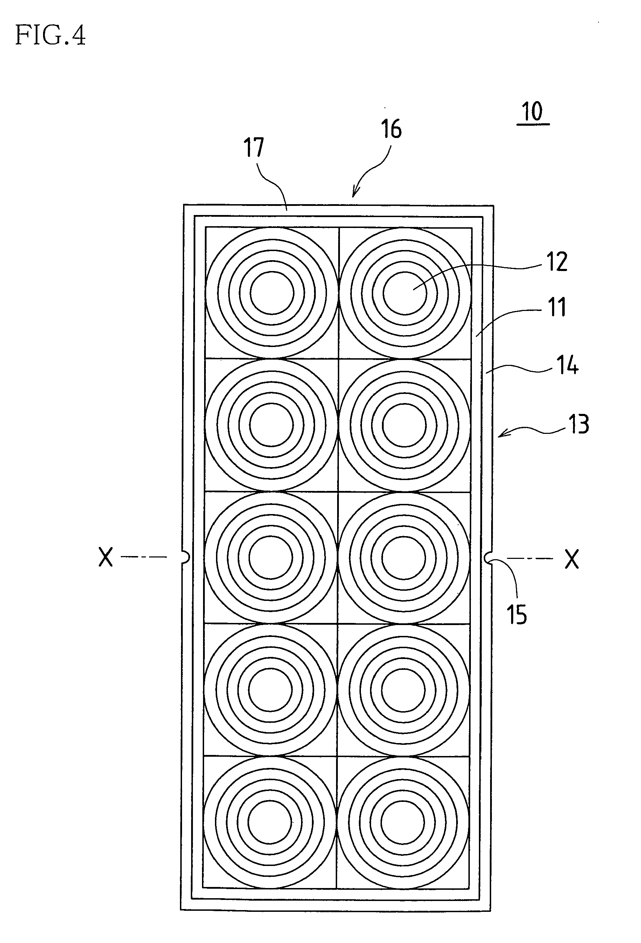

FIG. 4 is a plan view showing a plane configuration of the concentrating lens panel of the concentrating solar power generation unit according to Embodiment 1 of the present invention.

The concentrating lens panel 10 shown in FIG. 1 includes a rectangular light transmitting panel substrate 11 that is defined by first direction sides 13 (lengthwise direction/long sides) and second direction sides 16 (widthwise direction/short sides) that intersect each other, and further includes a plurality of concentrating lenses 12 that are disposed on a side of the light transmitting panel substrate 11 that faces solar cells 20, first direction side frame portions 14 that are formed on the perimeter edges of the first direction sides 13 and that protect the perimeter edges, and panel positioning portions 15 that are formed in a part of the first direction side frame portions 14 so as to correspond to the concentrating lens panel 10 (the center position of the concentrating lenses 12).

It is preferable that the concentrating lenses 12 are arranged in at least two rows on the light transmitting panel substrate 11. With this configuration, the panel positioning portions 15 can be disposed at a position where a straight line (e.g., reference line X-X) connecting the centers of the concentrating lenses 12 arranged in respective rows intersects the first direction side frame portions 14 formed in the light transmitting panel substrate 11, and therefore the position of the panel positioning portions 15 can be determined with high accuracy.

As described above, the panel positioning portions 15 are positioned with respect to the center of the concentrating lenses 12 that are predisposed on the light transmitting panel substrate 11 corresponding to the solar cells 20, and therefore the positioning accuracy of the light transmitting panel substrate 11 (concentrating lenses 12) to the solar cells 20 can be reliably improved.

In addition, because the center of the concentrating lenses 12 that is located at the center in the lengthwise direction of a plurality of (e.g., ten) concentrating lenses 12 is set as the reference point, the influence of stretches (displacement) due to thermal expansion of the light transmitting panel substrate 11, the elongated frame 30 and the solar cell mounting plate 21 that occur in both edges in the lengthwise direction of the light transmitting panel substrate 11 can be minimized, and therefore the heat resistance and the power generation efficiency can be improved.

It is preferable that each row including concentrating lenses 12 includes an odd number of concentrating lenses 12. With this configuration, the positioning of the panel positioning portions 15 can be performed easily and highly accurately by using the center line (reference line X-X) connecting two centers of the concentrating lenses that are located at the centers of the rows.

As described above, because the panel positioning portions 15 each can be disposed in correspondence with the center of the concentrating lenses 12 that is positioned at the center of the row, the position of the panel positioning portions 15 can be determined with respect to the edges of the rows with good balance and high accuracy, and therefore the influence of displacement at the edges of the rows due to thermal expansion can be minimized.

In addition, because the center of the concentrating lenses 12 that are arranged in two rows so as to correspond to the second direction sides 16 (widthwise direction) of the light transmitting panel substrate 11 is set as the reference point, two panel positioning portions 15 that are disposed in the lengthwise direction of the light transmitting panel substrate 11 can be reliably positioned with high accuracy.

With the method for manufacturing a concentrating solar power generation unit 1 of the present embodiment, for an elongated frame 30 (a bottom plate 31, first direction side supporting walls 32), a solar cell mounting plate 21 in which a plurality of solar cells 20 are mounted is disposed so as to correspond to a bottom plate 31, a light transmitting panel substrate 11 in which a plurality of concentrating lenses 12 corresponding to the solar cells 20 are arranged is disposed so as to correspond to first direction side supporting walls 32, first direction side frame portions 14 are inserted into frame insertion grooves 33, and panel positioning portions 15 are engaged with positioning portion-engagement portions 34. With such a simple method, the concentrating lens panel 10 can be matched and easily and highly accurately positioned to the elongated frame 30, and therefore a solar power generation unit manufacturing method that has extremely high productivity and superior mass productivity can be obtained.

In addition, the concentrating lens panel 10 of the present embodiment includes second direction side frame portions 17 that are formed covering perimeter edges of second direction sides that intersect the first direction sides in the light transmitting panel substrate 11, and the first direction side frame portions 14 and the second direction side frame portions 17 are integrally formed. Accordingly, the second direction side frame portions 17 can be easily and highly accurately formed with good productivity and low cost.

It should be noted that the number of concentrating lenses 12 disposed on the light transmitting panel substrate 11 and the number of solar cells 20 disposed on the solar cell mounting plate 21 can be determined in consideration of heat resistance, thermal expansion properties, productivity, reliability, maintainability and the like of the concentrating lens group defined in the light transmitting panel substrate 11 or the solar cell mounting plate 21 which is the unit of a single solar cell mounting unit.

As described above, it is possible to configure concentrating solar power generation units 1 that include an appropriate number of concentrating lenses 12 and solar cells 20 according to the usage.

In the present embodiment, a plurality of concentrating lenses 12 are arranged in rows on the light transmitting panel substrate 11 so as to correspond to the solar cells 20, forming a concentrating lens array (e.g., a total of ten (2x5)) corresponding to a unit region (light transmitting panel substrate 11) of a concentrating lens group disposed as an elongated shape.

The solar cell mounting plate 21 is configured to have an elongated shape corresponding to the light transmitting panel substrate 11, and a plurality of solar cells 20 are mounted in rows in the lengthwise direction, forming a solar cell array (e.g., a total of ten (2×5)) corresponding to an elongated mounting unit region.

The solar cell mounting plate 21 (receiver substrate) is made of, for example, an aluminum plate in consideration of weight reduction and heat dissipation properties. The solar cells 20 are disposed such that each solar cell is disposed so as to correspond to the center of each of light concentrating unit regions (sunlight irradiation holes formed in the bottom plate 31) that are formed in correspondence with the concentrating lenses 12. The solar cell mounting plate 21 (receiver substrate) is configured to secure appropriate insulating properties and provide power of the solar cells 20.

### Embodiment 2

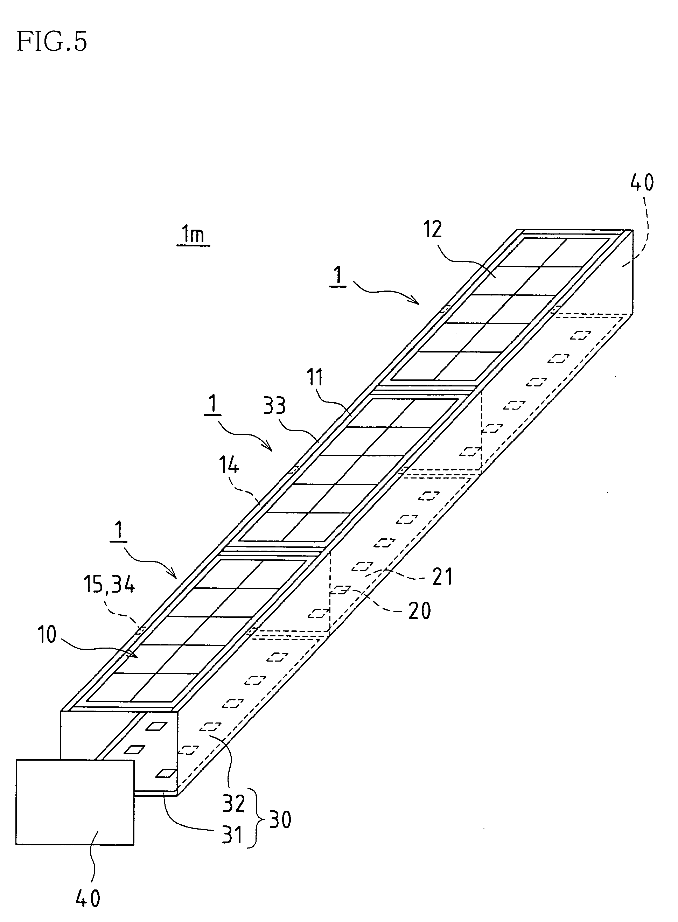

A concentrating solar power generation unit according to the present embodiment will be described with reference to FIG. 5. The concentrating solar power generation unit of the present embodiment is a combination of concentrating solar power generation units 1 of Embodiment 1.

FIG. 5 is a partially exploded perspective view of a concentrating solar power generation unit according to Embodiment 2 of the present invention.

A concentrating solar power generation unit 1m of the present embodiment includes, for example, three concentrating solar power generation units 1 that are disposed in the extension direction of the first direction sides 13 (elongated frame 30). The basic configuration is the same as that of Embodiment 1, which is thus referred to as appropriate, and differences are mainly described here.

The three concentrating solar power generation units 1 each include, as described in Embodiment 1, a concentrating lens panel 10, an elongated frame 30 and a solar cell mounting plate 21. In the present embodiment, the elongated frames 30 (first direction side supporting walls 32) of the three concentrating solar power generation units 1 have the same common basic structure. In other words, the elongated frames 30 are connected so as to continuously extend in the direction in which the three concentrating solar power generation units 1 are disposed.

The frame insertion grooves 33 are also connected so as to continuously extend corresponding to the elongated frames 30. Accordingly, concentrating lens panels 10 can be smoothly connected to the elongated frames 30, and therefore high productivity can be secured.

The light transmitting panel substrate 11 (concentrating lenses 12) and the solar cell mounting plate 21 (solar cells 20) are disposed in each concentrating solar power generation unit 1. Accordingly, it is only necessary to consider heat resistance, thermal expansion properties, productivity, reliability, maintainability and the like for each concentrating solar power generation unit 1, and even when three concentrating solar power generation units 1 are disposed and connected in the extension direction of the elongated frames 30 to form a concentrating solar power generation unit 1m, the same superior properties as those of the concentrating solar power generation unit 1 can be obtained.

The concentrating solar power generation unit 1m (concentrating solar power generation units 1) includes second direction side supporting walls 40 that extend in a direction intersecting the solar cell mounting plates 21 and that support the second direction side frame portions 17. In other words, by covering the terminal ends in the lengthwise direction of the elongated frame 30 with appropriate second direction side supporting walls 40, the end faces can be sealed.

Accordingly, because all sides of a concentrating lens panel 10 can be supported and stabilized, it is possible to dispose a large number of concentrating lenses 12 on the concentrating lens panel 10, and therefore a concentrating solar power generation unit 1m (concentrating solar power generation units 1) can be obtained with good productivity and low cost. In addition, the second direction side supporting walls 40 improve the strength of the elongated frame 30 as well as the dimensional accuracy of the shape, and shield the inside of the elongated frame 30 from the external environment, and therefore it is possible to protect the solar cells 20 and improve the reliability of the concentrating solar power generation unit 1m.

### Embodiment 3

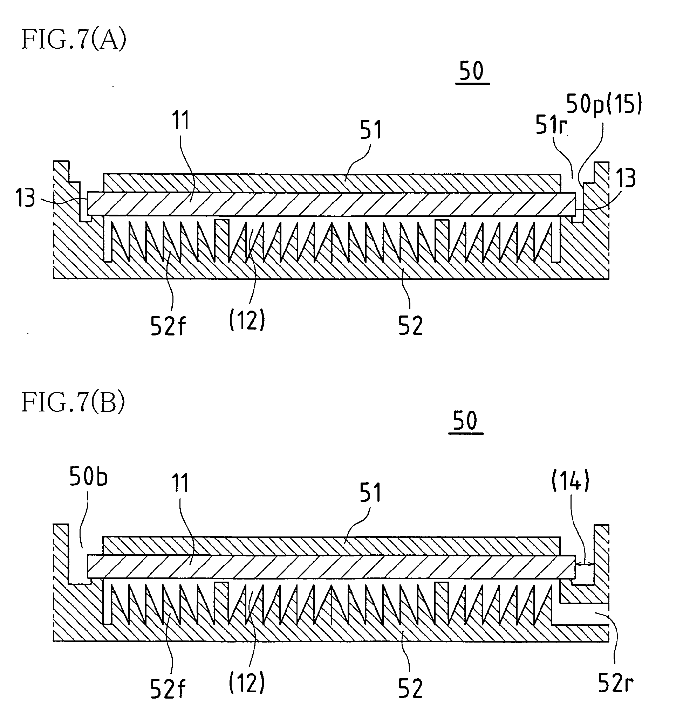

A method for manufacturing a concentrating solar power generation unit according to the present embodiment will be described with reference to FIGS. 6 and 7. The method for manufacturing a concentrating solar power generation unit of the present embodiment is the same as the method for manufacturing a concentrating solar power generation unit described in Embodiment 1, and thus a description relating mainly to details is given here. The basic configuration is the same as that of Embodiment 1 and thus referred to as appropriate.

As in the method for manufacturing a concentrating solar power generation unit described in Embodiment 1, a method for manufacturing a concentrating solar power generation unit of the present embodiment includes: a frame portion forming step of forming first direction side frame portions 14 that cover the perimeter edges of first direction sides 13 and panel positioning portions 15 that define the position of a concentrating lens panel 10; and a lens panel connecting step of connecting the concentrating lens panel 10 to first direction side supporting walls 32 by inserting the first direction side frame portions 14 into frame insertion grooves 33 that are disposed in upper portions of the first direction side supporting walls 32 and that include positioning portion-engagement portions 34 with which the panel positioning portions 15 are engaged, and engaging the panel positioning portions 15 with the positioning portion-engagement portions 34.

The second direction side frame portions 17 can be formed simultaneously in the same manner as the first direction side frame portions 14 are formed, and therefore a description thereof is omitted as appropriate.

FIG. 6 is a plan view showing an arrangement of a die and a light transmitting panel substrate in a frame resin injecting step of a method for manufacturing a concentrating solar power generation unit according to Embodiment 3 of the present invention.

FIGS. 7 show enlarged cross sections of the arrangement of a die and a light transmitting panel substrate shown in FIG. 6, with FIG. 7(A) being an enlarged cross-sectional view taken along the line A-A of FIG. 6, and FIG. 7(B) being an enlarged cross-sectional view taken along the line B-B of FIG. 6.

The frame portion forming step of forming first direction side frame portions 14 (panel positioning portions 15, second direction side frame portions 17) is carried out by a molding technique in which a resin is injected using a die 50 (including an upper die 51 and a lower die 52). Hereinafter, the upper die 51 and the lower die 52 are referred to simply as a die 50 where it is unnecessary to distinguish them.

The frame portion forming step can be divided into the following steps. Specifically, the frame portion forming step includes: a panel substrate placing step of placing a light transmitting panel substrate 11 on a die 50 (lower die 52); a lens resin injecting step of injecting a lens forming resin that forms concentrating lenses 12 on the light transmitting panel substrate 11 into the die 50 (a space formed by the upper die 51 and the lower die 52); a frame resin injecting step of injecting a frame portion forming resin that forms first direction side frame portions 14 into the die 50 (a space formed by the upper die 51 and the lower die 52); and a resin curing step of curing the lens forming resin and the frame portion forming resin that have been injected into the die 50.

Accordingly, concentrating lenses 12 and first direction side frame portions 14 can be formed integrally with a concentrating lens panel 10, and therefore it is possible to form the concentrating lenses 12 and the first direction side frame portions 14 with ease and high accuracy.

The upper die 51 has a flat face that corresponds to a light transmitting panel substrate 11 in order to protect the surface of the light transmitting panel substrate 11 from the resin (lens forming resin, frame portion forming resin). The lower die 52 has a concentrating lens forming portion 52f configured to have, for example, concentrically-arranged triangular waveform irregularities in order to form concentrating lenses 12.

In the frame portion forming step, first, a light transmitting panel substrate 11 is positioned to and placed on the lower die 52 (panel substrate placing step). Next, the upper die 51 that has been positioned to the lower die 52 is brought into contact with the light transmitting panel substrate 11. In other words, the light transmitting panel substrate 11 is pressed by the upper die 51, and the upper die 51 and the lower die 52 are disposed so as to face each other (panel substrate placing step).

The space created between the facing upper die 51 and lower die 52 is a space for forming a first direction side frame portion 14 (frame forming portion 50b). Also, the space created between the light transmitting panel substrate 11 and the lower die 52 (concentrating lens forming portion 52f) is a space for forming concentrating lenses 12.

The upper die 51 includes a resin injection inlet 51r for injecting a frame portion forming resin, and the lower die 52 includes a lower injection inlet 52r for injecting a lens forming resin. The die 50 (lower die 52) includes a positioning portion-forming portion 50p (a space having a shape that is reversed from the shape of panel positioning portion 15) for forming a panel positioning portion 15.

As described above, the positioning portion-configuring portion 50p (panel positioning portion 15) is disposed at a position at which a line connecting the centers of the concentrating lenses 12 arranged in two rows (corresponding to the position indicated by the line A-A) intersects a region in which a first direction side frame portion 14 is to be formed. Accordingly, it is possible to form panel positioning portions 15 that are highly accurately positioned to the concentrating lenses 12.

Next, the lens resin injecting step and the frame resin injecting step are carried out. The lens resin injecting step and the frame resin injecting step may be carried out simultaneously or either may be carried out before the other. For example, in the case where the lens resin injecting step and the frame resin injecting step are carried out simultaneously, a lens forming resin is injected from the lower injection inlet 52r and a frame portion forming resin is injected from the resin injection inlet 51r.

Next, the die is subjected to room temperature or a heat treatment to cure the resin (the lens forming resin and the frame portion forming resin) so as to form concentrating lenses 12 and first direction side frame portions 14 having panel positioning portions 15 in the light transmitting panel substrate 11. In other words, the resin curing step of curing the lens forming resin and the frame portion forming resin that have been injected into the die 50 is carried out.

As described above, with the frame portion forming step of the present embodiment, it is possible to form concentrating lenses 12, first direction side frame portions 14 and panel positioning portions 15 together in a light transmitting panel substrate 11, and by adjusting the dimensions of the die 50, it is possible to form highly accurate light transmitting panel substrates 11 that correspond to the outer dimensions of light transmitting panel substrates 11.

The concentrating lenses 12 and the first direction side frame portions 14 are made of, for example, acrylic resin in consideration of processability, light-transmitting properties and the like. It is also possible to use polycarbonate, glass, silicone resin or the like, instead of acrylic resin.

The outer shape of the concentrating lens panel 10 is defined by the first direction side frame portions 14 (and the second direction side frame portions 17). Accordingly, even if the light transmitting panel substrate 11 has a different outer shape size, or a slight deviation occurs during positioning in the panel substrate placing step, the outer shape size of the light transmitting panel substrate 11 is defined by the die 50 (die 50b), and therefore a constant shape can be secured. In other words, it is possible to manufacture light transmitting panel substrates 11 that have a highly accurate outer shape size and in which the concentrating lenses 12 and the panel positioning portions 15 are highly accurately positioned.

### Embodiment 4

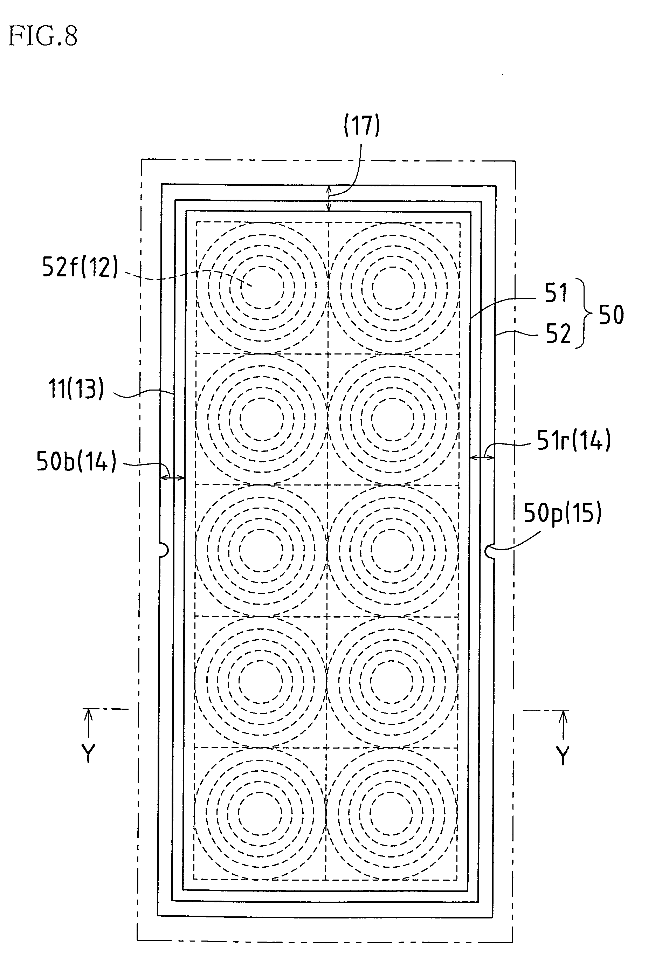

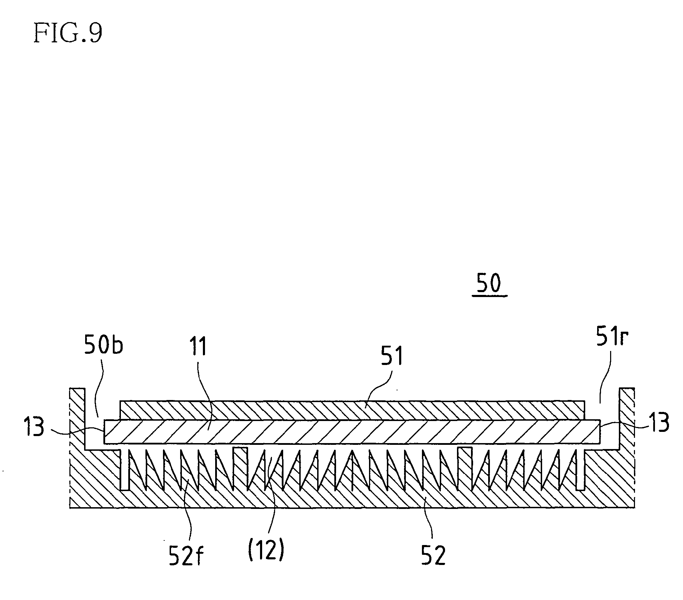

A method for manufacturing a concentrating solar power generation unit according to the present embodiment will be described with reference to FIGS. 8 and 9. The method for manufacturing a concentrating solar power generation unit of the present embodiment is the same as that described in Embodiment 3, and thus a description relating mainly to further details is given here. The basic configuration is the same as that of Embodiment 3 and thus referred to as appropriate.

In the present embodiment, the lens forming resin used in the lens resin injecting step and the frame portion forming resin used in the frame resin injecting step are the same resin. In other words, the lens resin injecting step and the frame resin injecting step are performed as a simultaneous resin injecting step of simultaneously injecting the same resin.

Accordingly, the concentrating lenses 12 and the first direction side frame portion 14 can be formed easily at low cost. Also, because the first direction side frame portion 14 and the concentrating lenses 12 are made of the same resin, the concentrating lenses 12 and panel positioning portions 14 can be formed simultaneously and their positional relationship can be defined with high accuracy, as a result of which the positional relationship between the concentrating lenses 12 and the solar cells 20 can be defined easily and highly accurately, further improving the accuracy of the light concentrating position.

Because the concentrating lenses 12 and the first direction side frame portions 14 are simultaneously molded using the same resin, they can be continuously molded as an integral piece, so the positional accuracy can be improved.

FIG. 8 is a plan view showing an arrangement of a die and a light transmitting panel substrate during a frame resin injecting step of a method for manufacturing a concentrating solar power generation unit according to Embodiment 4 of the present invention.

FIG. 9 is an enlarged cross-sectional view showing a cross section of the arrangement of a die and a light transmitting panel substrate shown in FIG. 8 taken along the line Y-Y.

The frame portion forming step of the present embodiment can be divided into the following steps. In other words, the frame portion forming step includes: a panel substrate placing step of placing a light transmitting panel substrate 11 on a die 50 (lower die 52); a simultaneous resin injecting step of simultaneously injecting a lens forming resin that forms concentrating lenses 12 in the light transmitting panel substrate 11 and a frame portion forming resin that forms first direction side frame portions 14 into the die 50 (a space formed by the upper die 51 and the lower die 52) as the same resin; and a resin curing step of curing the lens forming resin and the frame portion forming resin that have been injected into the die 50.

As described above, because the lens forming resin and the frame portion forming resin are the same resin, the injection of resin into the die 50 can be performed via the resin injection inlet 51r, and therefore the shape of the die 50 and the process can be simplified.

### Embodiment 5

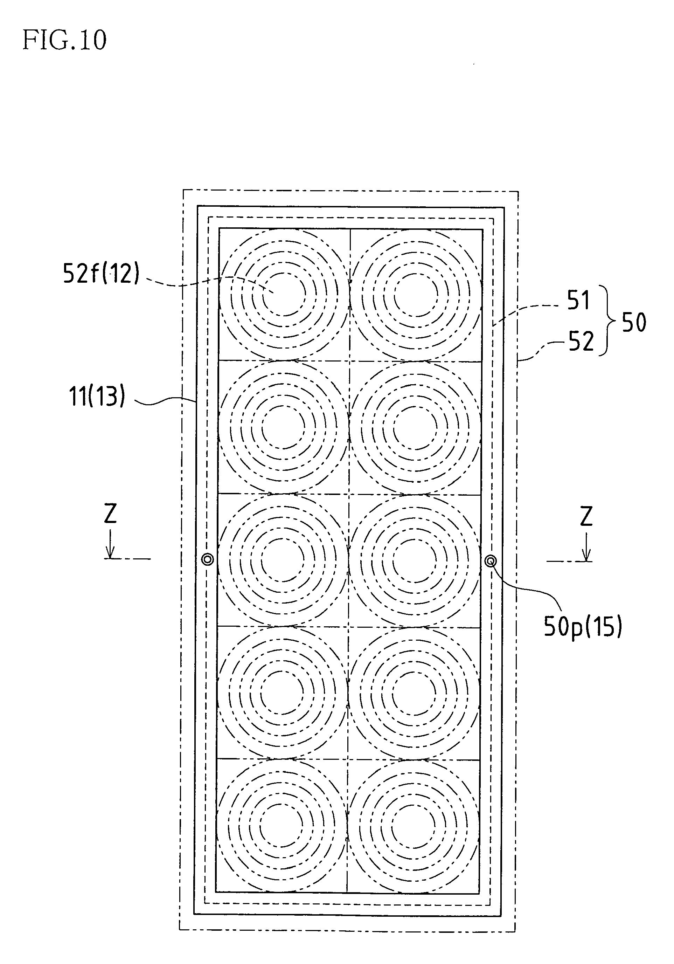

A positioning structure of a light transmitting panel substrate 11 is shown in FIGS. 10 to 13.

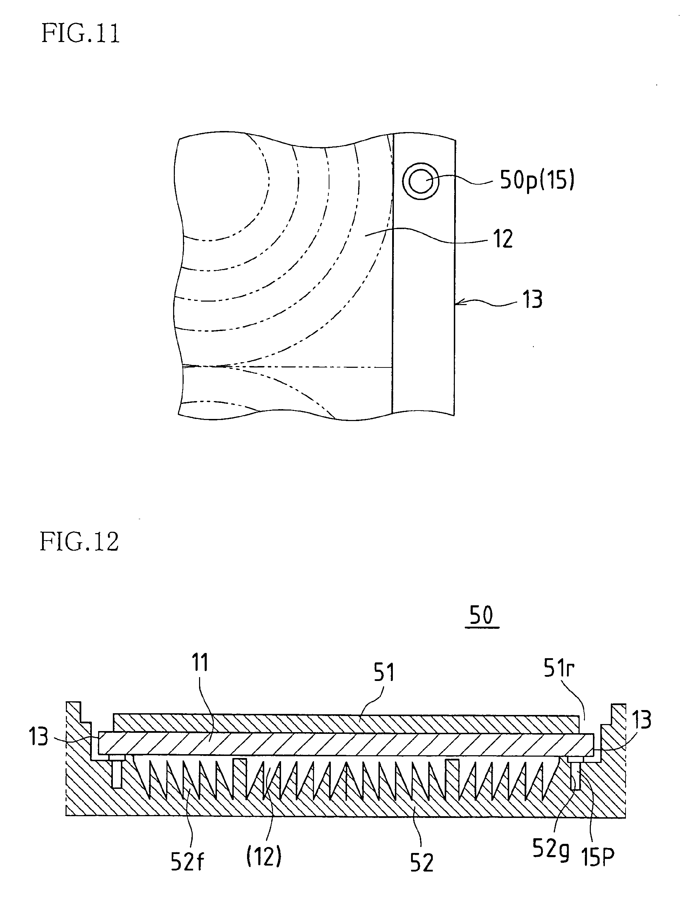

First, in the present embodiment, as shown in FIGS. 10 and 11, panel positioning portions 15 are formed corresponding to the center of concentrating lenses 12 that are disposed on a light transmitting panel substrate 11, as in the above embodiment. The present embodiment is different from the above embodiment in that the panel positioning portions 15 are formed in first direction sides 13 of the light transmitting panel substrate 11 as a positioning structure of the light transmitting panel substrate 11. Positioning portion-engagement portions with which the panel positioning portions 15 are engaged are formed in upper portions of first direction side supporting walls (not shown) that support the first direction sides 13.

In the present embodiment, as shown in FIG. 12, positioning pins 15P serving as panel positioning portions are two-color molded with lens forming dies 51 and 52 when molding the concentrating lenses 12. Cavities 52g for forming the pins 15P are provided in the die for molding concentrating lenses 12, so that the pins 15P can be formed simultaneously when the concentrating lenses 12 are formed.

In this case, the lens forming resin is required to have appropriate transmittance, refractive index, and the like. The resin used as a material for the pins 15P that is a projection serving as a panel positioning portion is required to have strength and provide height. From this point of view, in the present embodiment, two-color molding is performed.

In the case of forming a panel positioning portion by using a resin to mechanically provide a positioning function as described above, it is necessary to increase the hardness of the molded resin as the height of the projection (pin) as a panel positioning portion is increased. However, in the present embodiment, because the panel positioning portions are not required to have height, there is no problem with the lenses themselves.

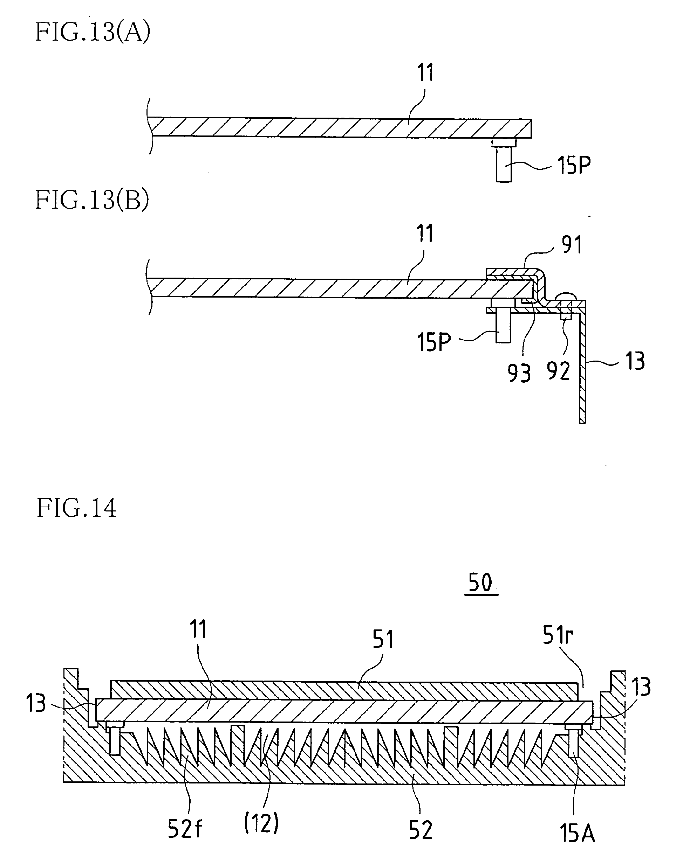

The thus-formed light transmitting panel substrate 11 including the pins 15P (FIG. 13(A)) is fixed to a first direction side 13 via a cushion 93 by a metal press 91 as shown in FIG. 13(B). The metal press 91 is also fixed to the first direction side 13 by a fixing tool 92. As the cushion 93, a resin such as a rubber or elastomer can be used. As the fixing tool 92, a screw, bolt, rivet or the like can be used.

### Embodiment 6

In Embodiment 5, as a panel positioning portion, positioning pins 15P are formed by two-color molding using the lens forming dies 51 and 52, whereas in Embodiment 6, these pins are formed in a separate step. The pins 15A formed in a separate step are fixed to a light transmitting panel substrate 11. Specifically, as shown in FIG. 14, pins 15A are placed in the lower die 52 of the lens forming die in advance, and the pins 15A are fixed to a light transmitting panel substrate 11 by fusing or bonding at the same time when molding concentrating lenses 12, whereby the pins 15A are fixed to the light transmitting panel substrate 11 with high bonding strength. As a method for increasing the bonding strength, a method can be used in which part of the pins 15A (a fixing point in the light transmitting panel substrate 11) is coated with the same resin as used for concentrating lenses 12 and the pins 15A are bonded to the light transmitting panel substrate 11 via the resin.

### Embodiment 7

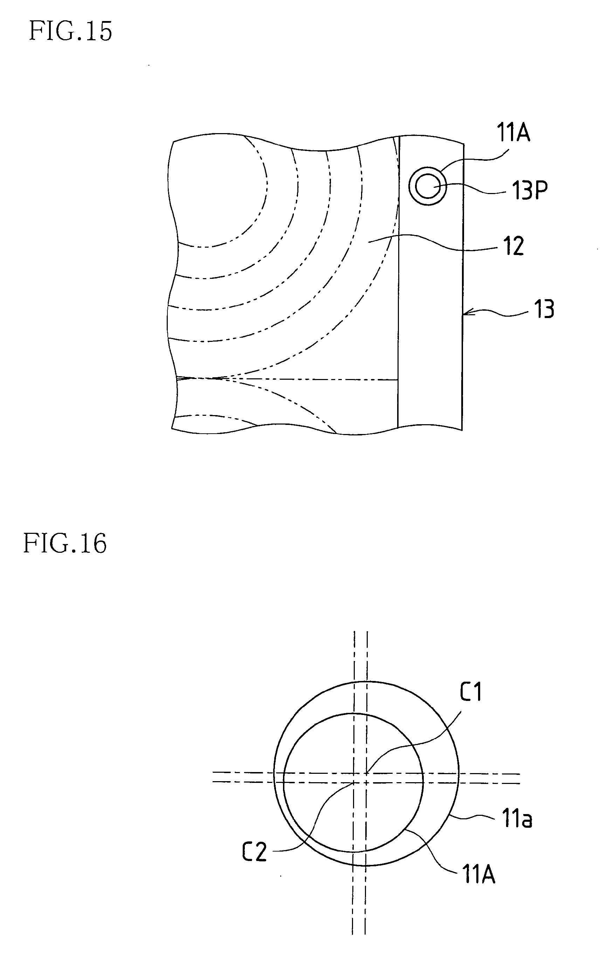

A concentrating solar power generation unit according to Embodiment 7 will be described with reference to FIGS. 15 to 18.

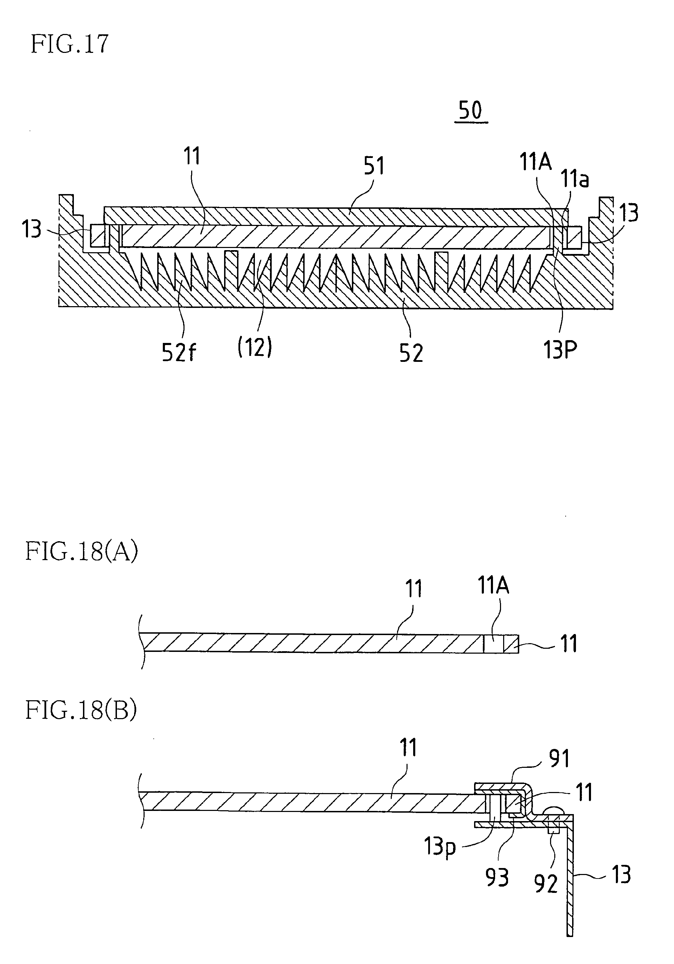

In Embodiment 7, as a configuration of a panel positioning portion, as shown in FIG. 17, a reference positioning aperture 11a is formed that passes through a prescribed portion of a light transmitting panel substrate 11 that faces a first direction side 13, an upper die 51 is inserted into the reference positioning aperture 11, and a resin is injected into the reference positioning aperture 11a to form a positioning aperture 11A with the same die. The positioning aperture 11A formed in this manner using the same die has a high degree of accuracy. In this case, as shown in FIG. 16, the center C1 of the reference positioning aperture 11a and the center C2 of the positioning aperture 11A do not necessarily coincide with each other, but the positional accuracy between the center of the concentrating lenses 12 and the center C2 of the positioning aperture 11A as a resin aperture can be obtained sufficiently.

The positioning aperture 11A can cope with a required accuracy of 0.1 mm in the reference positioning aperture 11a formed in the light transmitting panel substrate 11, which has poor accuracy (in an order of mm).

With the above configuration, by fitting a pin 13P formed in a first direction side 13 into the positioning aperture 11A, concentrating lenses 12 can be easily positioned.

Specifically, a light transmitting panel substrate 11 in which a positioning aperture 11A has been formed (FIG. 18(A)) is positioned with the pin 13P inserted into the positioning aperture 11A as shown in FIG. 18(B), and is fixed to the first direction side 13 by a metal press 91 via a cushion 93. The metal press 91 is also fixed to the first direction side 13 by a fixing tool 92. Specific examples used as the cushion 93 and the fixing tool 92 are the same as those described in Embodiment 5, so a description thereof is omitted here.

### Industrial Applicability

With the concentrating solar power generation unit and the manufacturing method thereof according to the present invention, concentrating solar power generation units that have superior light concentrating properties and heat resistance can be mass produced with good productivity and low cost, and therefore the present invention can sufficiently cope with the demand for realization of power supply by concentrating solar power generation apparatuses and is useful.

## Claims

1. A concentrating solar power generation unit comprising: a concentrating lens panel in which a plurality of concentrating lenses are arranged on a rectangular light transmitting panel substrate; a solar cell mounting plate in which solar cells are mounted in correspondence with the concentrating lenses; and a first direction side supporting wall that extends in a direction intersecting the solar cell mounting plate and that supports a first direction side of the light transmitting panel substrate,
wherein a panel positioning portion that defines a position of the concentrating lens panel is formed in the first direction side, and
a positioning portion-engagement portion with which the panel positioning portion is engaged is formed in an upper portion of the first direction side supporting wall.

2. The concentrating solar power generation unit according to claim 1,
wherein a reference positioning aperture is formed in the first direction side, and the panel positioning portion is formed covering the reference positioning aperture.

3. A concentrating solar power generation unit comprising: a concentrating lens panel in which a plurality of concentrating lenses are arranged on a rectangular light transmitting panel substrate; a solar cell mounting plate in which solar cells are mounted in correspondence with the concentrating lenses; and a first direction side supporting wall that extends in a direction intersecting the solar cell mounting plate and that supports a first direction side of the light transmitting panel substrate,
wherein the concentrating solar power generation unit comprises a first direction side frame portion that is formed covering a perimeter edge of the first direction side, and
the first direction side frame portion is provided with a panel positioning portion.

4. The concentrating solar power generation unit according to claim 3,
wherein a frame insertion groove is provided that is formed in an upper portion of the first direction side supporting wall and in which the first direction side frame portion is inserted, and
a positioning portion-engagement portion is formed in the frame insertion groove.

5. The concentrating solar power generation unit according to claim 4,
wherein the first direction side frame portion is in intimate contact with the frame insertion groove in a thickness direction of the first direction side frame portion.

6. The concentrating solar power generation unit according to claim 4 or 5,
wherein the first direction side frame portion and the concentrating lenses are made of the same resin.

7. The concentrating solar power generation unit according to any one of claims 1 to 6, comprising:
a second direction side frame portion that is formed covering a perimeter edge of a second direction side that intersects the first direction side in the light transmitting panel substrate; and
a second direction side supporting wall that extends in a direction intersecting the solar cell mounting plate and that supports the second direction side frame portion.

8. The concentrating solar power generation unit according to claim 7,
wherein the first direction side frame portion and the second direction side frame portion are integrally molded.

9. A method for manufacturing a concentrating solar power generation unit including: a concentrating lens panel in which a plurality of concentrating lenses are arranged on a rectangular light transmitting panel substrate; a solar cell mounting plate in which solar cells are mounted in correspondence with the concentrating lenses; and a first direction side supporting wall that extends in a direction intersecting the solar cell mounting plate and that supports a first direction side of the light transmitting panel substrate,
the method comprising steps of forming a panel positioning portion that defines a position of the concentrating lens panel in the first direction side, and forming a positioning portion-engagement portion with which the panel positioning portion is engaged in an upper portion of the first direction side supporting wall.

10. A method for manufacturing a concentrating solar power generation unit including: a concentrating lens panel in which a plurality of concentrating lenses are arranged on a rectangular light transmitting panel substrate; a solar cell mounting plate in which solar cells are mounted in correspondence with the concentrating lenses; and a first direction side supporting wall that extends in a direction intersecting the solar cell mounting plate and that supports a first direction side of the light transmitting panel substrate, the method comprising:
a frame portion forming step of forming a first direction side frame portion that covers a perimeter edge of the first direction side and a panel positioning portion that defines a position of the concentrating lens panel; and
a lens panel connecting step of connecting the concentrating lens panel to the first direction side supporting wall by inserting the first direction side frame portion to a frame insertion groove that is disposed in an upper portion of the first direction side supporting wall and that is provided with a positioning portion-engagement portion with which the panel positioning portion is engaged, and engaging the panel positioning portion with the positioning portion-engagement portion.

11. The method for manufacturing a concentrating solar power generation unit according to claim 10,
wherein the frame portion forming step comprises: a panel substrate placing step of placing the light transmitting panel substrate on a die; a lens resin injecting step of injecting a lens forming resin that forms the concentrating lenses on the light transmitting panel substrate into the die; a frame resin injecting step of injecting a frame portion forming resin that forms the first direction side frame portion into the die; and a resin curing step of curing the lens forming resin and the frame portion forming resin that have been injected into the die.

12. The method for manufacturing a concentrating solar power generation unit according to claim 11,
wherein the lens forming resin and the frame portion forming resin are the same resin, and the lens resin injecting step and the frame resin injecting step are performed as a simultaneous resin injecting step of simultaneously injecting the same resin.
